# EUROPEAN PATENT SPECIFICATION

(11) **EP 0 868 648 B1**
(45) Date of publication and mention of the grant of the patent: **02.04.2003**
(21) Application number: 96943712.8
(22) Date of filing: 10.12.1996
(51) Int. Cl.: G01B 7/34, G01N 27/00

(54) **INTEGRATED SILICON PROFILOMETER AND AFM HEAD**
INTEGRIERTER SILIKONPROFILMESSER UND RASTERSONDE
PROFILOMETRE A SILICIUM INTEGRE ET TETE POUR MICROSCOPIE A FORCES ATOMIQUES

(30) Priority: 11.12.1995 US 8495 P
(43) Date of publication of application: 07.10.1998
(73) Proprietor: Xros, Inc., Mountain View, CA 94043 (US)
(72) Inventor: NEUKERMANS, Armand, P., Palo Alto, CA 94303 (US); SLATER, Thimothy, G., San Francisco, CA 94122 (US)
(74) Representative: Crawford, Andrew Birkby
(86) International application number: US9619772
(87) International publication number: WO97021977

(56) References cited:
- DE-A- 3 029 019
- DE-A- 3 606 471
- US-A- 4 506 154
- US-A- 5 051 379
- US-A- 5 116 462
- US-A- 5 171 992
- US-A- 5 201 992
- US-A- 5 267 471
- US-A- 5 282 924
- US-A- 5 285 142
- US-A- 5 298 975
- US-A- 5 412 980
- US-A- 5 488 862

## Description

### Technical Field

The present invention relates generally to that area of metrologic technology concerned with measuring a surface's topology, and, more particularly, to profilometry, and to atomic force microscopy ("AFM), also sometimes referred to as scanning force microscopy ("SFM").

### Background Art

Recently, the field of surface profilometry has expanded greatly. In addition to advances in classical profilometry, the nascent fields of tunneling force microscopy and AFM have greatly enlarged the interest, scope and capability of profilometric technology.

Classical profilometry scans a surface along orthogonal X-axis and Y-axis directions using a diamond tipped stylus while measuring the stylus' vertical (Z-axis) displacement. In many commercial instruments, the stylus is connected to a linear variable differential transformer ("LVDT") sensor, or to a capacitive plate, for sensing the stylus' vertical displacement. Typically, the stylus includes an elongated bar that is secured with a pair of coaxial pivots, while the other end of the stylus is coupled to the Z-axis displacement sensing mechanism, e.g. either a capacitor's plate for a capacitive sensor, or a ferromagnetic plunger of the LVDT sensor.

Very sensitive flexure pivot assemblies are commonly used for supporting the stylus used for classical profilometry. The components of such a flexure pivot assembly are small, delicate, require precision assembly, and therefore are expensive to manufacture. In addition, machining such stylus assemblies from discrete components tends to make them comparatively large, and the sensing elements to which they couple are also relatively large. Therefore, profilometer heads including the stylus are, in general, larger than desirable. Consequently, profilometer heads generally respond slowly to vertical displacements, and the scanning speed at which profilometers operate is limited by the inertia of the profilometer's head. Hence, improving profilometer performance while concurrently reducing their manufacturing cost and contact force makes gentler, smaller, lighter, faster and less expensive profiling heads very desirable.

The more recently developing field of AFM for measuring a surface's topography generally uses a very light, micromachined, bendable cantilever probe having a sharp tip for sensing a surface's topology at atomic dimensions. However, systems for detecting minute vertical displacement of an AFM's sensing probe, e.g. optical-beam-deflection or optical interferometry, are, in general, much larger than the cantilever itself. Consequently, it is generally difficult to move an AFM's head assembly as swiftly as desired for high speed scanning. Traditionally, AFM systems circumvented this problem by holding the sensing head assembly stationary while moving the sample along orthogonal X and Y axes. Although such a system may move small samples easily during AFM scanning, it is generally unsuited for use on large samples, such as semiconductor wafers or magnetic recording disks measuring several inches in diameter.

Accordingly, not only does AFM necessarily require a physically small AFM sensing probe, but advancing AFM technology and performance also makes a correspondingly small, light weight, and compact sensor for detecting AFM probe Z-axis displacement desirable. Integration of a compact vertical displacement sensor into an AFM probe would yield a small, light weight, and compact AFM head having a low mass. Such a low mass AFM probe would permit very high speed scanning along orthogonal X-axis and Y-axis directions by a small and compact X-axis and Y-axis drives.

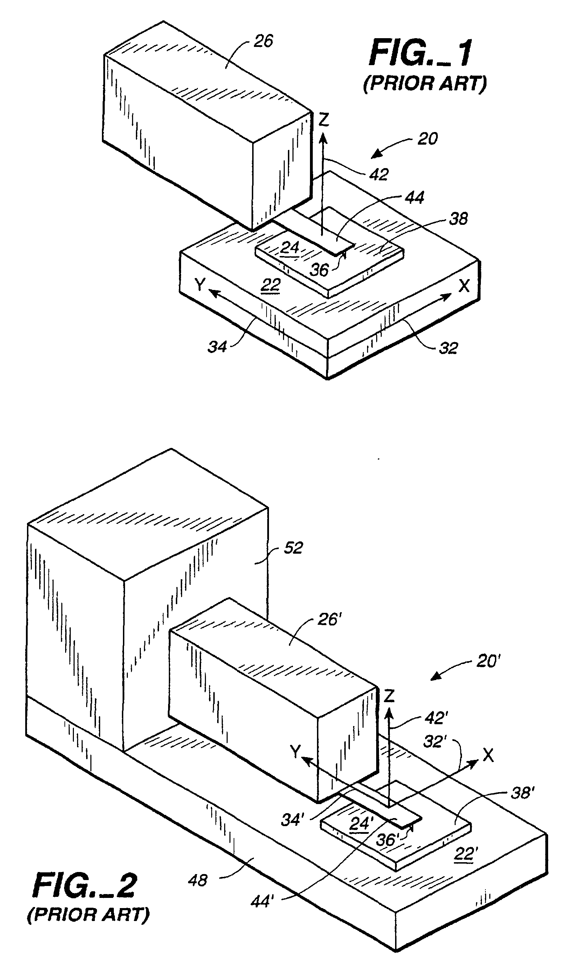

Referring now to FIG. 1, depicted there is a prior art AFM or profilometer system referred to by the general reference character 20. The system 20 includes a XY axes drive 22 upon which rests a sample 24. The XY axes drive 22 scans the sample 24 laterally with respect to a sensing head 26 along a X-axis 32 and a Y-axis 34 that are orthogonal to each other, or along any other arbitrary axes obtained by compound motion along the X-axis 32 and the Y-axis 34. In the instance of an AFM, to provide rapid movement along the axes 32 and 34 the XY axes drive 22 may be provided by a piezo electric tube having 4 quadrant electrodes. As the XY axes drive 22 moves the sample 24 laterally, a probe tip or stylus 36 lightly contacts an upper surface 38 of the sample 24 while moving up and down vertically parallel to a Z-axis 42 in response to the topology of the upper surface 38. In the illustration of FIG. 1, the probe tip or stylus 36 is secured to a distal end of an elongated cantilever arm 44 extending outward from the sensing head 26. The sensing head 26, which may if necessary be servoed up and down parallel to the Z-axis 42, senses vertical deflection of the probe tip or stylus 36 by the topology of the sample's upper surface 38. A signal transmitted from the sensing head 26 to some type of signal processing device permits recording and/or displaying the topology of the upper surface 38 as detected by the system 20.

AFM applications of systems such as of the system 20 experience substantial cross coupling among movements along the mutually perpendicular axes 32, 34, and 42. Consequently, movement of the sample 24 with respect to the AFM sensing head 26, and frequently even the measurement of such movement, are insufficiently precise for metrologic applications. Consequently, at present AFM performance may be adequate for imaging, but not for metrology. The mass of the sample 24 itself (such as an 8 inch diameter semiconductor wafer) impedes high speed, precise movement of the sample 24. Therefore, scanning a massive sample 24 swiftly requires holding the sample 24 fixed while scanning the sensing head 26.

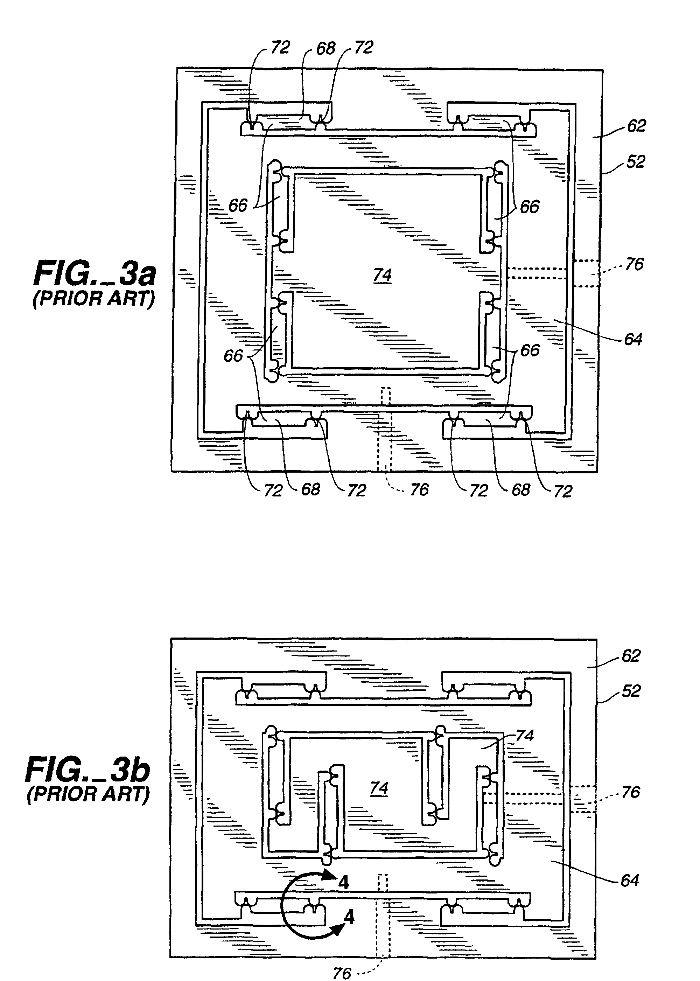

FIG. 2 depicts an alternative embodiment, prior art AFM or profilometer system. Those elements depicted in FIG. 2 that are common to the AFM or profilometer system depicted in FIG. 1 carry the same reference numeral distinguished by a prime (') designation. In the system 20' depicted in FIG. 2, the sample 24' rests on a base plate 48 which also supports a XY stage 52. In scanning the sample 24' using the system 20', the XY stage 52 moves the sensing head 26' carrying the cantilever arm 44' parallel to the orthogonal X-axis 32' and Y-axis 34', or along any other arbitrary axes obtained by compound motion along the X-axis 32' and the Y-axis 34'.

E. Clayton Teague, et al., in a technical article entitled "Para-flex Stage for Microtopographic Mapping" published the January 1988, issue of the Review of Scientific Instruments, vol. 59 at pp. 67-73 ("the Teague et al. article"), reports development of a monolithic, Para-flex XY stage 52, that the article describes as being machined out of metal. The embodiments of the monolithic plate of such an XY stage 52 is depicted both in FIG. 3a and 3b. The XY stage 52 depicted in both FIGs. includes an outer base 62 that is fixed with respect to the system 20'. The outer base 62 is coupled to and supports a Y-axis stage 64 by means of four stage suspensions 66. Each of the stage suspensions 66 consists of an intermediate bar 68, one end of which is coupled to the outer base 62 by a flexure 72, and another, distal end of the intermediate bar 68 is coupled to the Y-axis stage 64 by a second symmetrical flexure 72. Similar to the coupling of the outer base 62 to the Y-axis stage 64, the Y-axis stage 64 is coupled to and supports a X-axis stage 74 by means of four stage suspensions 66 that are identical to the stage suspensions 66 which couple the outer base 62 to the Y-axis stage 64. The stage suspensions 66 coupling the outer base 62 to the Y-axis stage 64 and the stage suspensions 66 coupling the Y-axis stage 64 to the X-axis stage 74 are oriented perpendicular to each other. Consequently, the inner X-axis stage 74 moves substantially perpendicularly to movement of the Y-axis stage 64, with both stages 64 and 74 moving with great accuracy with respect to the outer base 62. Movement of the stages 64 and 74 with respect to the outer base 62 is effected by a pair of mutually orthogonal stepping-motor-controlled micrometer screw drives, not illustrated in any of the FIGs., which respectively have a pushrod connection to the Y-axis stage 64 and the X-axis stage 74. The screw drives extend from outside the outer base 62 through drive apertures 76 to respectively contact the Y-axis stage 64 and the X-axis stage 74. The XY stage 52 depicted in FIG. 3b differs from that depicted in FIG. 3a in that the stage suspensions 66 coupling the Y-axis stage 64 to the X-axis stage 74 are folded which reduces the space occupied by the XY stage 52. The XY stage 52 reported by C. Teague, et al. provides accurate movement along mutually perpendicular axes 32' and 34'. However, the XY stage 52 depicted in FIGs. 3a and 3b provides no motion amplification.

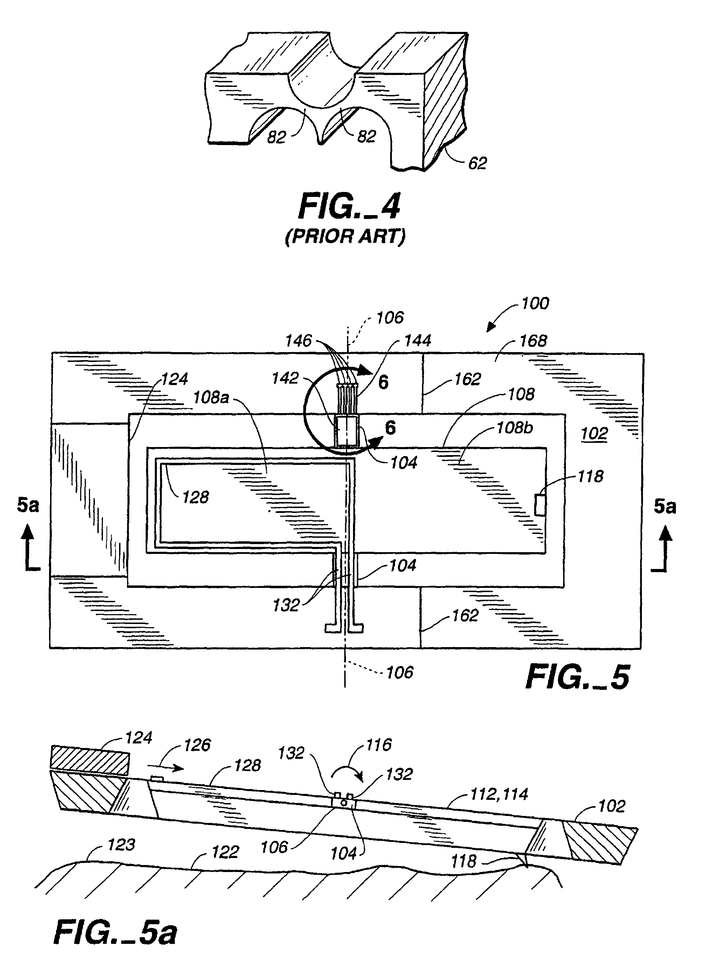

FIG. 4 depicts the flexure 72 indicated on the XY stage 52 depicted in FIG. 3b. The flexure 72 employs a pair of webs 82 arranged in a W-shaped configuration to span between the outer base 62 and the intermediate bar 68, between the intermediate bar 68 and the Y-axis stage 64, between the Y-axis stage 64 and the intermediate bar 68, and between the intermediate bar 68 and the X-axis stage 74. The flexure 72 depicted in FIG. 4 permits both longitudinal stretching and rotation.

If the XY stage 52 is made by conventional techniques, even a monolithic XY stage 52 such as that disclosed in the Teague et al. article, the resonance frequency is typically a few hundred Hz. Stepping-motor-controlled micrometer screw drives or other forms of push rods for displacing the XY stage 52 are typically limited to relatively low frequency operation. Consequently, the XY stage 52 of an AFM can only be served at relatively low speed.

Recent advances in reactive ion etching processes and apparatus for etching silicon permit forming deep vertical structures. For example the new Alcatel etcher produces etching aspect ratios of 300/1, and therefore permits etching through wafers several hundred microns thick. Other etchers having similar performance are now available. Some techniques for wet etching, (such as [100] orientation etching), may also be used to fabricate structures having correspondingly high aspect ratios. These improved processes permit construction of structures of metrologic precision with macro dimensions. This method therefore makes it possible to construct structures of aspect ratios that normally can only be achieved by EDM (electric discharge machining) of metals. These advances in micromachined silicon fabrication technology permits executing classical designs for the XY stage 52 to provide metrologic quality.

### Disclosure of Invention

An object of the present invention is to provide an AFM XYZ stage having a very fast response.

Another object of the present invention is to provide a metrologic quality XY stage.

Another object of the present invention is to provide an AFM XYZ stage that is simpler to fabricate.

Briefly, the present invention is a micromachined XYZ stage for supporting, and carrying for X-axis, Y-axis and Z-axis translation, various different types of scanning microscopy sensors such as the topograph sensor described above, or an optical near-field, tunneling or field-emission microscope sensor. The XYZ stage includes an outer stage-base that is adapted to be held fixed with respect to a surface to be scanned. The outer stage-base is coupled to and supports an intermediate X-axis stage via a plurality of flexures disposed between the outer stage-base and the intermediate X-axis stage. At least one of the flexures coupling between the stage-base and the X-axis stage has a shear stress sensor formed therein for sensing stress in that flexure. The intermediate X-axis stage is coupled to and supports an inner Y-axis stage via a plurality of flexures. At least one of the flexures coupling between the X-axis stage and the Y-axis stage has a shear stress sensor formed therein for sensing stress in that flexure. The stage-base, X-axis stage, Y-axis stage, and flexures are all monolithically fabricated f rev a semiconductor wafer. A Z-axis stage may also be included to provide an integrated XYZ stage.

The present invention also includes a micromachined, topographic head, adapted for use in sensing topography of a surface, that has an outer frame from which torsion bars project inwardly to support a central paddle. The torsion bars are aligned along a common axis thereby permitting the central paddle to rotate about the common axis. The frame, torsion bars and central paddle are all monolithically fabricated from a semiconductor single-crystal silicon wafer. The central paddle defines a rest plane if no external force is applied to the central paddle, and is rotatable about the common axis by a force applied to the central paddle. The central paddle also includes a tip that projects outward from the central paddle distal from the torsion bars, the tip being adapted for sensing the topography of a surface. The topographic head also includes drive means for imparting rotary motion to the central paddle about the common axis, and a rotational-position sensing means for measuring the rotational position of the central paddle about the common axis of the torsion bars.

The preferred Z-axis stage is in many ways similar to the topographic head described above. The preferred Z-axis stage has torsion bars that project inwardly from opposing sides of the Y-axis stage. The torsion bars are aligned along a common axis for supporting a Z-axis paddle within the Y-axis stage. The torsion bars and Z-axis paddle are preferably monolithically fabricated from a semiconductor single-crystal silicon layer of a substrate together with the stage-base, X-axis stage, Y-axis stage, and flexures. The torsion bars support the Z-axis paddle within the Y-axis stage for rotation about the torsion bars' common axis. An external force is applied to the Z-axis paddle causes the Z-axis paddle to rotate about the common axis to a rotational-position displaced from the Z-axis paddle's rest plane. The Z-axis stage includes a drive means, preferably piezo-electric disks for urging to the Z-axis paddle to rotate about the common axis of the torsion bars. A rotational-position sensing means, preferably integrated into the torsion bars, measures the rotational-position of the Z-axis paddle about the common axis of the torsion bars.

The Z-axis stage of the XYZ stage may carry an AFM sensor that adapts the XYZ stage for sensing topography of a surface. More specifically, the AFM mead may be the topographic head described above. Accordingly, the AFM sensor carried by the Z-axis stage includes torsion bars that project inwardly from opposing sides of an outer frame, and are aligned along a common axis to support a central paddle within the Y-axis stage, The torsion bars and central paddle are all monolithically fabricated from a semiconductor single-crystal silicon layer of a substrate. The central paddle is supported for rotation about the common axis of the torsion bars and defines a rest plane if no external force is applied to the central paddle. A force applied to the central paddle may rotate it around the common axis of the torsion bars to a rotational-position displaced from the rest plane. The central paddle includes a tip that projects outward from an end of the central paddle distal from the torsion bars. The tip is adapted for juxtaposition with a surface for sensing the topography thereof.

The preceding invention provides integration in silicon of the mechanical components and the electrical sensors required by topographic head. Accordingly, the present invention substantially enhances the performance of profilometers and AFMs, and reduces their size, while at the same time reducing their cost.

These and other features, objects and advantages will be understood or apparent to those of ordinary skill in the art from the following detailed description of the preferred embodiment as illustrated in the various drawing figures.

### Brief Description of Drawings

FIG. 1 is a diagram that depicts one embodiment of a prior art AFM or profilometer system in which an XY stage moves a sample laterally while sensing vertical (Z-axis) deflection of a probe tip or stylus;
FIG. 2 is a diagram that depicts an alternative embodiment of a prior art AFM or profilometer system in which a sample is held fixed while an XY stage moves a sensing head laterally while the head senses vertical (Z-axis) deflection of a probe tip or stylus;
FIGs. 3a and 3b are a plan views illustrated alternative embodiments of a monolithic, Paraflex XY stage adapted for use in AFM of a type reported by C. Teague, et al.;
FIG. 4 is a perspective view depicting a flexure incorporated into the monolithic, Paraflex XY stage illustrated in FIGs. 3a and 3b;
FIG. 5 is a plan view depicting the frame, torsion bar and central paddle of a topographic head in accordance with the present invention;
FIG. 5a is a cross-sectional view of the topographic head depicted in FIG. 5 taken along the line 5a-5a;
FIGS. 6a and 6b are plan views depicting alternative embodiments of a four-terminal torsion sensor located on a torsion bar taken along a line 6-6 in FIG. 5;
FIG. 6c is plan view, similar to the plan views of FIGs. 6a and 6b, that depicts yet another alternative embodiment of the torsion sensor having only three-terminals;
FIG. 7 is a plan view of a micromachined XYZ scanning stage in accordance with the present invention adapted for use in an AFM which employs flexures to permit lateral motion of the XY scanning stage with respect to a sample;
FIGs. 8a and 8b are alternative plan views of a flexure included in the XY scanning stage in accordance with the present invention taken along the line 16-16 of FIG. 7;
FIG. 9a is an enlarged plan view of a Z-axis stage included in the XYZ scanning stage taken within the line 17-17 of FIG. 7;
FIG. 9b is a cross-sectional view of the Z-axis stage taken along the line 17b-17b in FIG. 9a depicting fabrication of the XYZ scanning stage from bonded silicon wafers;
FIG. 10 is a cross-sectional view of a XY scanning stage, similar to the view of FIG. 9b depicting assembling and bonding together of the XY scanning stage from a stack of silicon wafers each of which has been pre-processed to form individual XY scanning stages; and
FIG. 11 is a cross-sectional plan view depicting piezo plates arranged in a face-to-face configuration and secured within a clamshell arrangement.

### Best Mode for Carrying Out the Invention

FIG. 5 depicts a micromachined topographic head in accordance with the present invention that is identified by the general reference character 100, and that is adapted for use in sensing topography of a surface. The topographic head 100 includes a planar frame 102 from which inwardly project a pair of opposing torsion bars 104. The torsion bars 104 are aligned along a common axis 106 and support a central paddle 108 within the frame 102. While FIG. 5a depicts the torsion bar 104 as having a rectangular cross-section, the torsion bars 104 need not necessarily have the aspect ratio depicted there. The cross-section of the torsion bars 104 may, in fact be square, rounded or trapezoidal. The frame 102, torsion bars 104 and central paddle 108 are all monolithically fabricated from a semiconductor single-crystal silicon layer of a substrate wafer. The central paddle 108 is rotatable about the common axis 106 of the torsion bars 104. When using a common [100] oriented silicon wafer, the torsion bars 104 are preferably oriented along the [100] crystallographic direction, or the [110] crystallographic direction. The torsion bars 104 may be hardened by conversion of a surface layer therof into silicon carbide or silicon nitride. The physical properties of the torsion bars 104 in relationship to the central paddle 108, particularly with respect to vibrational modes, are those described in United States Patent US-5,629,790.

With no external force applied to the central paddle 108, a planar surface 112 of the central paddle 108 defines a rest plane 114 illustrated in FIG. 5a. If an external force is applied to the central paddle 108, the central paddle 108 will be displaced from the rest plane 114 as indicated by a curved arrow 116. The central paddle 108 also includes a tip 118 that projects outward from the central paddle 108 distal from the torsion bars 104. As illustrated in FIG. 5a, the tip 118 is adapted to be juxtaposed with a surface 122 of a sample 123 for sensing the topography thereof.

The topographic head 100 also preferably includes a small permanent magnet 124 (or electromagnet) located on the frame 102 which provides a magnetic field 126, indicated by an arrow in FIG. 5a, that is oriented parallel to the rest plane 114. A planar coil 128, having a pair of coil leads 132 that are brought out onto the frame 102 via one of the torsion bars 104, is deposited on the planar surface 112 of the central paddle 108. The planar coil 128 may consist of a single turn coil as illustrated in FIG. 5, or it may consist of a multiple turn coil. In the latter case, an overlap of one turn or a wire bond connection must be provided in one of the coil leads 132. An electric current flowing through the planar coil 128 generates a magnetic field which interacts with the magnetic field 126 from the permanent magnet 124 to apply a torque to the central paddle 108 that urges the central paddle 108 to rotate about the common axis 106. Rotation of the central paddle 108 with respect to the frame 102 responsive to an electric current through the planar coil 128 permits controlling the force which the tip 118 applies to the surface 122.

The torsion bar 104 that does not carry the coil leads 132 preferably has a torsion sensor 142 formed thereon. The torsion sensor 142 is of the type described both in United States Patent US-5,629,790 identified above, and in United States Patent No. 5,488,862 entitled "Monolithic Silicon Rate-Gyro With Integrated Sensors" which issued on February 6, 1996, which was filed by the inventors of the present application.

As described in the patents identified above, the torsion sensor 142 preferably has four metallic sensor leads 144 which terminate on the frame 102 in individual torsion sensor pads 146. The torsion sensor pads 146 permit bonding or soldering to external leads, not illustrated in any of the FIGS. An electrical signal produced by the torsion sensor 142 permits sensing the rotational-position of the central paddle 108 about the common axis 106 of the torsion bars 104 with respect to the frame 102.

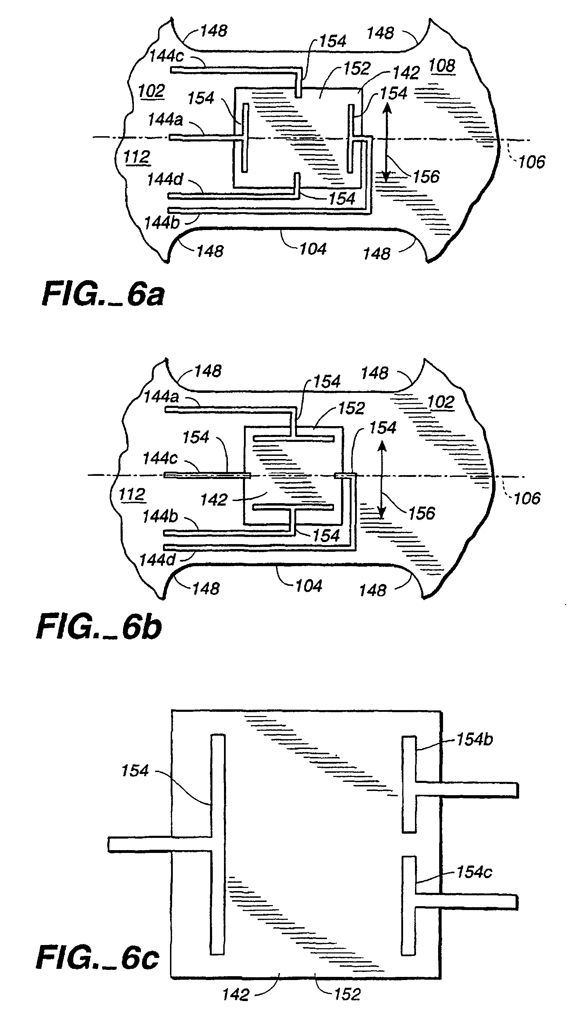

As described in the patent application and issued patent identified above and as illustrated in greater detail in FIGS. 6a and 6b, the torsion sensor 142 is preferably a four-terminal piezo sensor. FIG. 6a depicts an embodiment of the torsion sensor 142 in which an electric current flows parallel to the common axis 106. FIG. 6b depicts an alternative embodiment of the torsion sensor 142 in which an electric current flows perpendicular to the common axis 106. When using p-type [100] silicon material as a substrate for fabricating the torsion bars 104, the crystallographic direction of the torsion bar 104 should be along the [100] axis. When using n-type [100] silicon material as a substrate for fabricating the torsion bars 104, the crystallographic direction should be along the [110] axis. As set forth above, either of these crystallographic directions are compatible with fabrication of the torsion bars 104. FIGs. 6a and 6b also illustrate rounded corners 148 joining the torsion bars 104 to the frame 102 and to the central paddle 108.

To constrain electric current flowing through the torsion sensor 142 to the planar surface 112 of the torsion bar 104, a sensor region 152 of the torsion bar 104 is implanted or diffused with a dopant material. For example if torsion bar 104 is fabricated either using p-type or n-type substrate material oriented along [100] crystallographic direction, then a p+ dopant is implanted or diffused into the sensor region 152 of the planar surface 112. While implantation of a p+ dopant material into an n-type substrate produces a junction isolation, in either case the electric current will be constrained to the planar surface 112. Likewise if n-type or p-type substrate material is used with the torsion bar 104 oriented in the [110] crystallographic direction, an n+ dopant is implanted or diffused to produce an n-type sensor region 152 for the torsion sensor 142, either without or with junction isolation. If the torsion bars 104 are thick with respect to separation between opposing pairs of torsion sensor electrodes 154, in principle implantation or diffusion may be omitted.

The metallic sensor leads 144 all form ohmic contacts to the implanted or diffused sensor region 152, but are otherwise electrically isolated from the planar surface 112 of the torsion bar 104. During operation of the topographic head 100, an electric current is applied to torsion sensor leads 144a and 144b. Torsion stress in the torsion bar 104, illustrated in FIGs. 6a and 6b by a double-headed arrow 156, that results from rotation of the central paddle 108 with respect to the frame 102, generates a voltage between torsion sensor leads 144c and 144d. The voltage generated between the torsion sensor leads 144c and 144d is proportional to the current applied through torsion sensor leads 144a and 144b, and to the torsion (shear) stress 156 in the torsion bar 104. One advantage of the torsion sensor 142 is that it is insensitive to linear stresses in the torsion bar 104, such as those caused by the weight of the central paddle 108. However, the torsion bars 104 must be of very high, metrologic quality, and must be stress free. Accordingly, the topographic head 100 is preferably fabricated using SOI for the substrate material as described in the patent application and issued patent identified above. Alternatively, the topographic head 100 may be fabricated from conventional silicon wafers using a timed etch for controlling the thickness of the torsion bars 104.

FIG. 6c is an alternative embodiment of the torsion sensor 142 which splits one of the current torsion sensor electrodes 154 symmetrically in two parts 154a and 154b. Twisting the torsion bar 104 induces a differential change in the electric current flowing through the two halves of the torsion sensor electrodes 154b and 154c. In the torsion sensor 142 depicted in FIG. 6c, separate voltage sensing torsion sensor electrodes 154 are not required. All orientations of the torsion sensor 142 with respect to the crystallographic directions are otherwise identical to the four-terminal torsion sensor 142.

### XYZ Scanning Stage

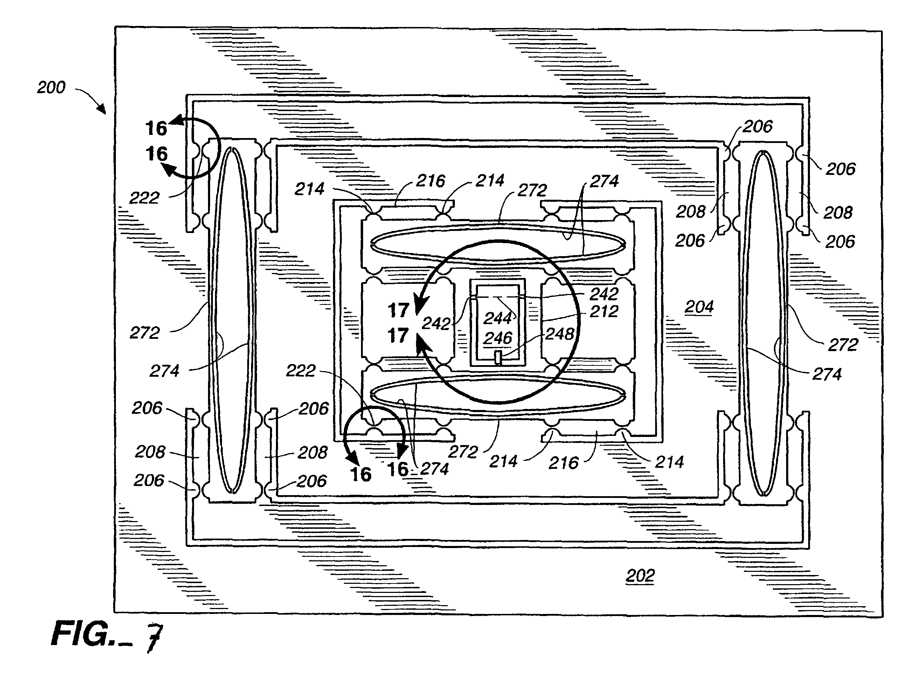

The plan view of FIG. 7 depicts a preferred embodiment of a micromachined XYZ scanning stage in accordance with the present invention, referred to by the general reference character 200, that is adapted for use in an AFM. The XYZ scanning stage 200 includes an outer stage-base 202 that forms a perimeter of the XYZ scanning stage 200, and that is adapted to be held fixed within the system 20' with respect to the surface 122 to be scanned. The stage-base 202 is coupled to and supports an intermediate X-axis stage 204 through a plurality of flexures 206. The flexures 206 are arranged in pairs with one pair being located at the stage-base 202 and the other being located at the X-axis stage 204, the pair of flexures 206 being joined by an intermediate bar 208. Use of this structure for the flexures 206 implements the principle of the double compound linear spring described in a technical article by 5. T. Smith et al. entitled "Design and Assessment of Monolithic High Precision Translation Mechanisms," that was published during 1987 in the Journal of Physics E: Scientific Instruments, vol. 20 at p. 977. An important characteristic of this arrangement for supporting the X-axis stage 204 with respect to the stage-base 202 is that there is there is no stretching of the flexures 206.

In the preferred embodiment of the XYZ scanning stage 200 depicted in FIG. 7, eight pairs of flexures 206, each coupled by the intermediate bar 208, join the stage-base 202 to the X-axis stage 204 to permit motion of the X-axis stage 204 laterally from side-to-side with respect to the stage-base 202. The X-axis stage 204 encircles, is coupled to and supports an inner Y-axis stage 212 by an arrangement of flexures 214 and intermediate bars 216 similar to that by which the stage-base 202 supports the X-axis stage 204. The flexures 214 and the intermediate bars 216 permit the Y-axis stage 212 to move laterally from side-to-side with respect to the X-axis stage 204. Thus compound lateral translation of the stage-base 202 with respect to the X-axis stage 204 and of the Y-axis stage 212 with respect to the X-axis stage 204 permits independent movement of the Y-axis stage 212 along mutually perpendiculary X and Y axes. The entire XYZ scanning stage 200, including the stage-base 202, the X-axis stage 204, the flexures 206, the intermediate bars 208, the Y-axis stage 212, the flexures 214 and the intermediate bars 216 are monolithically fabricated from a semiconductor single-crystal silicon layer of a substrate.

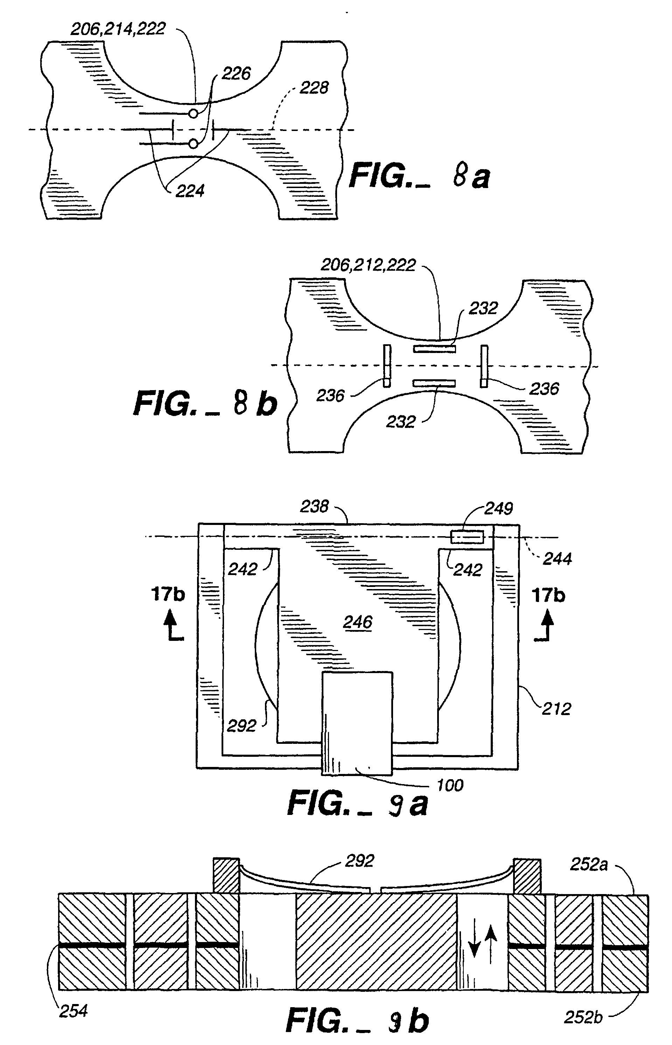

At least one of the flexures 206 and at least one of the flexures 214 includes a shear stress sensor 222 for sensing stress respectively in the flexure 206 or 214. FIGS. 8a and 8b are plan views depicting both the flexure 206 or the flexure 214 taken along the lines 16-16 in FIG. 7. The stress sensor 222 depicted in FIGs. 8a and 8b may be used to measure deflection of the flexures 206 and 214, and hence the stage deflection respectively along the X or Y axis. Even if longitudinal stresses appear in the flexures 206 and/or 214, the stress sensor 222 depicted in FIG. 8a is insensitive to such stresses, and properly indicates deflection along either the X or the Y axis. Since shear forces are greatest near the center of the flexures 206 and 214, the stress sensor 222, which in the illustration of FIG. 8a has a configuration similar to the torsion sensor 142 depicted in FIG. 6a, should be located on the flexure 206 or 214 as depicted in FIG 8a.

In the stress sensor 222 depicted in FIG. 6a, a pair of shear-sensor current-leads 224 provide an electric current to the stress sensor 222, and a pair of shear-sensor sensing-leads 226 sense a voltage induced by shear stress in the flexure 206 or 214. The voltage present on the shear-sensor sensing-leads 226 is proportional to deflection of the flexure 206 or 214. The center axis 228 of the flexure 206 or 214 should be oriented in the [100] crystallographic direction for p-type silicon, and in the [110] crystallographic direction for n-type silicon. However, the stress sensor 222 may be fabricated either with the orientation depicted in FIG. 8a, or in an orientation rotated at 90° from that depicted in FIG. 8a. The stress sensor 222 requires no particular current isolation such as that required for the torsion sensor 142 since the shear stress is the same throughout the thickness of the flexure 206 or 214. Since the shear stress is greatest in the center of the flexure 206 or 214, current through the stress sensor 222 flows preferably along the center axis 228.

An alternative bending stress sensor 222 depicted in FIG. 8b employs a pair of piezo resistors 232 disposed symmetrically on opposite sides of the center axis 228. In such a piezo resistor implementation, bending of the flexure 206 or 214 compresses one piezo resistor 232 while stretching the other piezo resistor 232. However, piezo resistors 232 respond both to bending stresses of the flexure 206 or 214 and to tensile or compressive stress along the center axis 228, to which the stress sensor 222 depicted in FIG. 8a is insensitive. Use of the piezo resistors 232 in a differential mode reduces sensitivity of the piezo resistors 232 to tensile or compressive stress along the center axis 228, while responding preferentially to bending stress in the flexure 206 or 214. The stress sensor 222 depicted in FIG. 8b may also include additional piezo resistors 234, preferably removed from the area of bending stresses and/or oriented to be insensitive to bending stress, e.g. perpendicular to and symmetrically about the center axis 228. The piezo resistors 234 may be electrically incorporated into a resistance bridge together with the piezo resistors 232 to provide temperature compensation for the stress sensor 222.

The Y-axis stage 212 may support and translate along X and Y axes various different types of scanning sensors such an optical near-field microscope, a tunneling microscope, a field emission microscope, or a topographic head 100 such as that described above. The embodiment of the XYZ scanning stage 200 depicted in FIG. 7 illustrates, in greater detail in FIGs. 9a and 9b, the XYZ scanning stage 200 supporting a topographic head 100. As depicted in those FIGs., the Y-axis stage 212 includes a Z-axis stage 238 having a pair of torsion bars 242 that project inwardly from opposing sides of the Y-axis stage 212. The torsion bars 242 are aligned along a common axis 244 for supporting a Z-axis paddle 246 within the Y-axis stage 212. The torsion bars 242 and the Z-axis paddle 246 are monolithically fabricated from a semiconductor single-crystal silicon layer of a substrate together with the stage-base 202, X-axis stage 204, Y-axis stage 212, the flexures 206 and 214, and the intermediate bars 208 and 216. Similar to the central paddle 108 described above, the Z-axis paddle 246, which is supported within the Y-axis stage 212 for rotation about the common axis 244 of the torsion bars 242, defines a rest plane if no external force is applied to the Z-axis paddle 246. The Z-axis paddle 246 is rotatable about the common axis 244 of the torsion bars 242 to a rotational-position displaced from the rest plane by a force applied to the Z-axis paddle 246. The Z-axis paddle 246 may carry a topographic head 100 such as that described above and below adapted for AFM that projects outward from the Z-axis paddle 246 distal from the torsion bars 242. One of the torsion bars 242 of the Z-axis stage 238 includes a torsion sensor 249 fabricated identically to the torsion sensor 142 described above, and that has a structure and rotational sensing function identical to the torsion sensor 142. The electrical signal produced by the torsion sensor 249 measures Z-axis motion of the Z-axis paddle 246 with respect to the Y-axis stage 212.

In fabricating the XYZ scanning stage 200, wafers may be etched from both sides with mirrored image masks (carefully aligned) to increase the depth of the flexures 206 and 214, and their height to width aspect ratio. Bonded wafers may be used as substrates for fabricating the XYZ scanning stage 200. FIG. 9b illustrates the XYZ scanning stage 200 fabricated in this manner in which the silicon wafer consists of 2 bonded wafers 252a and 252b. The bonded wafers 252a and 252b are joined through an oxide layer 254 between them which acts as an etch stop. The use of bonded wafers 252a and 252b allows doubling the aspect ratio of the flexures 206 and 214 by etching from both sides either with wet etching or reactive ion etching. If the wall angle of the flexures 206 and 214 differs from 90°, then this procedure provides a symmetric shape for the flexures 206 and 214 which ensures distortion free lateral translation of the Y-axis stage 212 with respect to the stage-base 202.

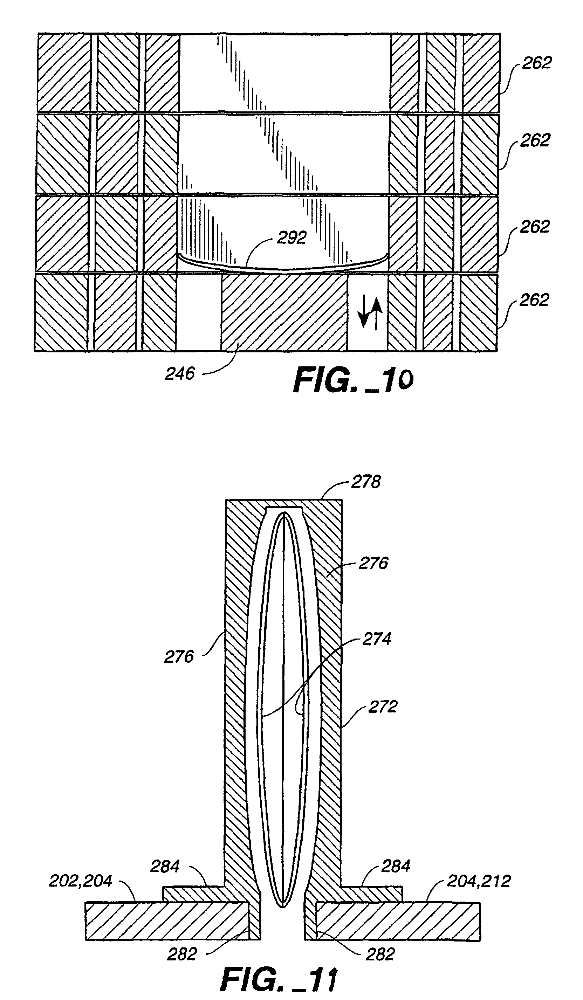

Even higher aspect ratios may be achieved for the flexures 206 and 214 by identically etching several semiconductor wafers 262, illustrated in FIG. 10, that include lithographically fabricated alignment holes. After the semiconductor wafers 262 have been fabricated, they may be stacked one on top of the other as depicted in FIG. 10, preferably in pairs of two wafers facing back-to-back. The XYZ scanning stages 200 in each of the semiconductor wafers 262 may be bonded or glued together. If side walls of the flexures 206 and 214 slope as generally occurs if the semiconductor wafers 262 are prepared using anisotropic wet etching, then the etch direction for each pair of semiconductor wafers 262 preferably alternates so the overall stack is symmetric. Only one of the semiconductor wafers 262, i.e. an outer wafer 262, need include the torsion bars 242, Z-axis paddle 246 and the stress sensor 222.

In principal the X-axis stage 204 and the Y-axis stage 212 could be translated laterally with respect to the stage-base 202 by a pair of mutually orthogonal stepping-motor-controlled micrometer screw drives such as those described in the Teague et al. article, or by another type of push-rod mechanism. However, translation of the X-axis stage 204 and the Y-axis stage 212 is preferably effected using thin piezo electric transducers 272 illustrated in FIG. 7. One pair of such piezo electric transducers 272 is interposed between the stage-base 202 and the X-axis stage 204 on opposite sides of the X-axis stage 204. Similarly, a second pair of such piezo electric transducers 272 is interposed between the X-axis stage 204 and the Y-axis stage 212 on opposite sides of the Y-axis stage 212. The piezo electric transducers 272 may be located in pockets created in the stage-base 202 and in the stages 204 and 212, and may be operated in tandem from either side if so desired. The piezo electric transducers 272 have a very low mass and inertia while displacing the stages 204 and 212 sufficiently for AFM operation. Arranged in this way, the X-axis stage 204 must carry the piezo electric transducers 272 for displacing the Y-axis stage 212. However, these piezo electric transducers 272are light, thus their mass does not significantly degrade the performance of the XYZ scanning stage 200.

The piezo electric transducers 272 may be provided either by thin piezo electric unimorph or bimorph disk or strip shaped plates 274 operating in the doming mode, preferably used in tandem. The piezo electric transducers 272 (either single or dual) consist preferably, as illustrated in FIG. 11, of 2 piezo plates 274, positioned face-to-face. The plates 274 may be fabricated from a thin circular disk of stress-biased lead lanthanum zirconia titanate ("PLZT") material. This material is manufactured by Aura Ceramics and sold under the "Rainbow" product designation. This PLZT unimorph provides a monolithic structure one side of which is a layer of conventional PLZT material. The other side of the PLZT unimorph is a compositionally reduced layer formed by chemically reducing the oxides in the native PLZT material to produce a conductive cermet layer. The conductive cermet layer typically comprises about 30 % of the total disk thickness. Removing of the oxide from one side of the unimorph shrinks the conductive cermet layer which bends the whole disk and puts the PLZT layer under compression. The PLZT layer is therefore convex while the conductive cermet layer is concave.

Regardless of the particular material system used for the plates 274, applying a voltage across the plates 274 causes them either to increase or decrease their curvature. If the piezo electric transducer 272 on one side of a stage 204 or 212 increases the curvature of the plates 274 while the plates 274 in the piezo electric transducer 272 on the other side decreases its curvature the stage will move laterally with respect to the surrounding stage-base 202 or X-axis stage 204.

The plates 274 may preferentially be put in a clamshell arrangement as illustrated in figure 11. The plates 274 are surrounded by metal clamps 276, which may have an interior surface shaped to reduce stress by conforming to the curvature of the plates 274. The two metal clamps 276 are free to rotate with respect to each other, and are held together by a small spring or a hinge clasp 278. The metal clamps 276, which project upward above the upper surface of the XYZ scanning stage 200, include jaws 282 that contact adjacent edges of the stage-base 202 and the X-axis stage 204, or of the X-axis stage 204 and the Y-axis stage 212. Preferably the jaws 282 may be coated with plastic. The metal clamps 276 may include lips 284 for gluing the piezo electric transducers 272 in place to the stages 204 and 212. The plates 274 are lapped to a thickness which matches the space between adjacent edges of the stage-base 202 and the X-axis stage 204, or of the X-axis stage 204 and the Y-axis stage 212; the clamshell is then compressed and inserted between the stage-base 202 and the X-axis stage 204, or between the X-axis stage 204 and the Y-axis stage 212. The preload on the piezo electric transducers 272 must be carefully controlled. The maximum contraction of the plates 274 in response to an applied voltage must be smaller than the preload compression, or the plates 274 will get loose with consequent loss of control over lateral movement of the Y-axis stage 212.

While as illustrated in FIG. 7 the preferred embodiment of the XYZ scanning stage 200 preferably uses a pair of piezo electric transducers 272 for displacing the Y-axis stage 212 along each of the X and Y axes. Such a dual arrangement of plates 274 on opposite sides of the stages 204 and 212 advantageously provides transducer preload, without pronounced deflection of the stage. However, a XYZ scanning stage 200 in accordance with the present invention need only use a single piezo electric transducer 272 for effecting movement along the X axis or along the Y axis. In such a XYZ scanning stage 200 having only a single piezo electric transducer. 272 per axis, each stage 204 and 212 must be preloaded against the piezo electric transducer 272 either by force generated within the flexures 206 and 214, or by a spring interposed between the stage-base 202 and the X―axis stage 204, and between the X-axis stage 204 and the Y-axis stage 212. These piezo electric transducers 272 can be inserted from the back of the XYZ scanning stage 200 so that the front is unencumbered and may be very close to the object to be scanned, if required.

To apply a force urging the topographic head 100 carried by the Z-axis paddle 246 toward a surface to be scanned, as illustrated in FIGS. 9a and 9b the XYZ scanning stage 200 includes a disk-shaped bimorph, unimorph or a Rainbow type, stress-biased PLZT piezo transducer 292 that contacts the Z-axis paddle 246. Upon application of a voltage to the piezo transducer 292, it deflects the cantilevered Z-axis paddle 246, thereby providing high frequency vertical motion along the Z-axis. The XYZ scanning stage 200 carrying the topographic head 100 may be used to measure the topography of the surface 122 in either of two different ways. In one mode of operation that may be identified as a constant force measurement, the electrical signal applied to the piezo transducer 292 maintains the signal from the torsion sensor 142 included in the topographic head 100 at a constant value thereby causing the tip 118 of the topographic head 100 to apply a constant force to the surface 122. In this mode of operation, the signal from the torsion sensor 249 indicates the topography of the surface 122. In an alternative mode of operation the electrical signal applied to the piezo transducer 292 holds the topographic head 100 at a fixed location and the signal from the torsion sensor 142 indicates the topography of the surface 122.

### Industrial Applicability

### XY Scanning Stage 200

A XYZ scanning stage 200 in accordance with the present invention may be fabricated having an outer dimension of 35 x 27 mm for the stage-base 202 while the inner Y-axis stage 212 is 5 x 5 mm. Each pair of flexures 214 and intermediate bars 216 is 3 mm long, 600 micron wide, 800 micron thick, and the thinnest part of the flexure 214 is 100 microns wide. The lowest resonance frequencies in such a system are all above 3000 Hz. Displacements of the Y-axis stage 212 along the X and Y axes may typically be 50 microns, and the Z axis displacement a few microns.

## Claims

1. A micromachined XY scanning stage comprising:
an outer stage-base (202) that is adapted to be held fixed with respect to a surface to be scanned;
an intermediate X-axis stage (204) that is coupled to and supported from the stage-base by a plurality of flexures (206),
an inner Y-axis stage (212) that is coupled to and supported from the X-axis stage (204) by a plurality of flexures (214)
and sensing means supported by, and carried for X-axis and Y-axis translation by, said X-axis stage and Y-axis stage;
**characterized in that**:
at least one of the flexures (206) coupling between said stage-base and said X-axis stage having a shear stress sensor (222) formed therein for sensing stress **in that** flexure;
at least one of the flexures (214) coupling between said X-axis stage and said Y-axis stage having a shear stress sensor (222) formed therein for sensing stress **in that** flexure; said stage-base, X-axis stage, Y-axis stage, and flexures all being monolithically fabricated from a semiconductor single-crystal silicon layer of a substrate.

2. The XY scanning stage of claim 1 wherein said sensing means adapts the XY scanning stage for sensing topography of a surface, said sensing means including:
a Z-axis stage (238) having torsion bars (242) that project inwardly from opposing sides of said Y-axis stage and are aligned along a common axis (244) for supporting a Z-axis paddle (246) within said Y-axis stage; said torsion bars and Z-axis paddle being monolithically fabricated-from a semiconductor single-crystal silicon layer of a substrate together with said stage-base, X-axis stage, Y-axis stage, and flexures; said Z-axis paddle being supported within the Y-axis stage for rotation about the common axis of the torsion bars, defining a rest plane if no external force is applied to said Z-axis paddle, and being rotatable about the common axis of said torsion bars to a rotational-position displaced from the rest plane by a force applied to said Z-axis paddle; said Z-axis paddle being adapted for carrying a scanning sensor;
drive means (292) for urging to said Z-axis paddle to rotate about the common axis of said torsion bars;
and rotational-position sensing means for measuring the rotational-position of said Z-axis paddle about the common axis of said torsion bars.

3. The XY scanning stage of claim 2 wherein the scanning sensor carried by said Z-axis stage is a micromachined topographic head (100) adapted for use in sensing topography of a surface, the topographic head including:
a frame (102) from which inwardly project opposing torsion bars (104) that are aligned along a common axis (106) and that support a central paddle (108) within said frame; said frame, torsion bars and central paddle all being monolithically fabricated from a semiconductor single-crystal silicon layer of a substrate; said central paddle being supported within the frame for rotation about the common axis of the torsion bars, having a center, defining a rest plane (114) if no external force is applied to said central paddle, and being rotatable about the common axis of said torsion bars to a rotational-position displaced from the rest plane by a force applied to said central paddle; said central paddle including a tip (118) that projects outward from said central paddle distal from said torsion bars, the tip being adapted for juxtaposition with a surface (122) for sensing the topography thereof;
drive means (124,128) for urging to said central paddle to rotate about the common axis of said torsion bars; and
rotational-position sensing means (142) for measuring the rotational-position of said central paddle about the common axis of said torsion bars.

4. The XY scanning stage of claim 2 wherein said drive means is a laminated metal unimorph that is coupled to said Z-axis paddle.

5. The XY scanning stage of claim 2 wherein said drive means is a bimorph that is coupled to said Z-axis paddle.

6. The XY scanning stage of claim 2 wherein said drive means is formed from stress-biased PLZT material of a Rainbow type of ceramic which has been processed so one side surface thereof has been compositionally reduced to obtain a material having a cermet composition, whereby the drive means constitutes a monolithic unimorph, the unimorph being coupled to said Z-axis paddle.

7. The XY scanning stage of claim 1 wherein the shear stress sensor includes a piezo sensor.

8. The XY scanning stage of claim 1 wherein the shear stress sensor includes a piezo resistor.

9. The XY scanning stage of claim 1 further comprising X-axis drive means.

10. The XY scanning stage of claim 9 wherein said X-axis drive means is interposed between said outer stage-base and said intermediate X-axis stage.

11. The XY scanning stage of claim 9 wherein said X-axis drive means is a piezo transducer (272) interposed between said outer stage-base and said intermediate X-axis stage.

12. The XY scanning stage of claim 11 wherein said piezo transducer is a laminated metal unimorph.

13. The XY scanning stage of claim 11 wherein said piezo transducer is a bimorph.

14. The XY scanning stage of claim 11 wherein said piezo transducer is formed from stress-biased PLZT material of a Rainbow type of ceramic which has been processed so one side surface thereof has been compositionally reduced to obtain a material having a cermet composition, whereby the piezo transducer constitutes a monolithic unimorph.

15. The XY scanning stage of claim 1 further comprising Y-axis drive means.

16. The XY scanning stage of claim 15 wherein said Y-axis drive means is interposed between said intermediate X-axis stage and said inner Y-axis stage.

17. The XY scanning stage of claim 15 wherein said Y-axis drive means is a piezo transducer (272) interposed between said intermediate X-axis stage and said inner Y-axis stage.

18. The XY scanning stage of claim 17 wherein said piezo transducer is a laminated metal unimorph.

19. The XY scanning stage of claim 17 wherein said piezo transducer is a bimorph.

20. The XY scanning stage of claim 17 wherein said piezo transducer is formed from stress-biased PLZT material of a Rainbow type of ceramic which has been processed so one side surface thereof has been compositionally reduced to obtain a material having a cermet composition, whereby the piezo transducer constitutes a monolithic unimorph.

## Revendications

1. Platine à déplacement programmé XY micro-usinée, comprenant :
une base de platine externe (202), qui est adaptée pour être retenue de façon fixe par rapport à une surface devant être explorée par balayage;
une platine intermédiaire (204) déplaçable suivant l'axe X, qui est couplée à et supportée par la base de la platine au moyen d'une pluralité de dispositif de flexion (206), une platine interne (212) déplaçable suivant l'axe Y, qui est couplée à et supportée par la platine (204) déplaçable suivant l'axe X, au moyen d'une pluralité de dispositifs de flexion (214), et
des moyens de détection supporté par et déplacés pour une translation suivant l'axe X et suivant l'axe Y par ladite platine déplaçable suivant l'axe X et ladite platine déplaçable suivant l'axe Y;
**caractérisée en ce que** :
au moins l'un des dispositifs de flexion (206) établissant un couplage entre ladite base de la platine et ladite platine déplaçable suivant l'axe X possède un capteur de contrainte de cisaillement (222) formé en lui pour détecter une contrainte dans le dispositif de flexion;
au moins l'un des dispositifs de flexion (214) réalisant le couplage entre ladite platine déplaçable suivant l'axe X et ladite platine déplaçable suivant l'axe Y possède au moins un capteur de contrainte de cisaillement (222) qui est formé en lui pour détecter une contrainte dans ce dispositif de flexion; ladite base de la platine, ladite platine déplaçable suivant l'axe X, ladite platine déplaçable suivant l'axe Y et les dispositifs de flexion étant tous fabriqués de façon monolithique à partir d'une couche de silicium monocristallin semiconducteur d'un substrat.

2. Platine à déplacement programmé XY selon la revendication 1, dans laquelle lesdits moyens de détection adaptent la platine à déplacement programmé XY pour la détection de la topographie d'une surface, lesdits moyens de détection comprenant :
une platine (238) déplaçable suivant l'axe Z et comportant des barres de torsion (242), qui font saillie vers l'intérieur à partir de côtés opposés de ladite platine déplaçable suivant l'axe Y et sont alignés le long d'un axe commun (234) pour supporter une palette (246) déplaçable suivant l'axe Z, dans une platine déplaçable suivant l'axe Y; lesdites barres de torsion et ladite palette déplaçable suivant l'axe Z étant réalisées de façon monolithique au moyen d'une couche de silicium monocristallin semiconducteur d'un substrat conjointement avec ladite base de la platine, ladite platine déplaçable suivant l'axe X, ladite platine déplaçable suivant l'axe Y et des dispositifs de flexion; ladite palette déplaçable suivant l'axe Z étant supportée dans la platine déplaçable suivant l'axe Y pour tourner autour de l'axe commun des barres de torsion, définissant un plan de repos si aucune force externe n'est appliquée à ladite palette déplaçable suivant l'axe Z, et pouvant tourner autour de l'axe commun desdites barres de torsion pour venir dans une position de rotation décalée par rapport au plan de repos, par une force appliquée à ladite palette déplaçable suivant l'axe Z; ladite palette déplaçable suivant l'axe Z étant adaptée pour déplacer un capteur d'exploration par balayage;
des moyens d'entraînement (292) pour appliquer une sollicitation à ladite palette déplaçable suivant l'axe Z, pour qu'elle tourne autour de l'axe commun desdites barres de torsion; et
des moyens de détection de la position en rotation pour mesurer la position en rotation de ladite palette déplaçable suivant l'axe Z, autour de l'axe commun desdites barres de torsion.

3. Platine à déplacement programmé XY selon la revendication 2, dans laquelle un capteur d'exploration par balayage entraîné par ladite platine déplaçable sur un axe Z est une tête topographique micro-usinée (100) adaptée pour être utilisée pour la détection de la topographie d'une surface, ladite tête topographique comprenant :
un cadre (102), à partir duquel font saillie vers l'intérieur des barres de torsion opposées (104), qui sont alignées le long d'un axe commun (106) et qui supportent une palette centrale (108) à l'intérieur dudit cadre; ledit cadre, lesdites barres de torsion et la palette centrale étant fabriqués de façon monolithique avec une couche de silicium monocristallin semiconducteur d'un substrat; ladite palette centrale étant supportée dans le cadre de manière à tourner autour de l'axe commun des barres de torsion, comportant un centre, définissant un plan de repos (114) si aucune force externe n'est appliquée à ladite palette central, et pouvant tourner autour de l'axe commun desdites barres de torsion pour venir dans une position de rotation décalée par rapport au plan de repos, par une force appliquée à ladite palette centrale; ladite palette centrale comprenant une pointe (118) qui fait saillie vers l'extérieur à partir de ladite palette centrale distale desdites barres de torsion, la pointe étant adaptée pour être juxtaposée à une surface (122) pour détecter la topographie de cette surface;
des moyens d'entraînement (124,128), servant à repousser ladite partie centrale de la palette pour tourner autour de l'axe commun desdites barres de torsion; et
des moyens (142) de détection de position de rotation pour mesurer la position de rotation de ladite palette centrale autour de l'axe commun desdites barres de torsion.

4. Platine à déplacement programmé XY selon la revendication 2, dans laquelle lesdits moyens d'entraînement sont une structure métallique unimorphe stratifiée, qui est couplée à ladite palette déplaçable suivant l'axe Z.

5. Platine à déplacement programmé XY selon la revendication 2, dans laquelle lesdits moyens d'entraînement sont une structure bimorphe qui est couplée à ladite palette déplaçable suivant l'axe Z.

6. Platine à déplacement programmé XY selon la revendication 2, dans laquelle lesdits moyens d'entraînement sont formés par un matériau PLZT sous contrainte, formé d'une céramique de type Rainbow, qui a été traitée de telle sorte que l'une de ses surfaces latérales a été réduite, du point de vue composition, pour l'obtention d'un métal possédant une composition de cermet, ce qui a pour effet que les moyens d'entraînement comprennent une structure unimorphe monolithique, la structure unimorphe étant couplée à ladite palette déplaçable suivant l'axe Z.

7. Platine à déplacement programmé XY selon la revendication 1, dans laquelle le capteur de contrainte de cisaillement inclut un capteur piézoélectrique.

8. Platine à déplacement programmé XY selon la revendication 1, dans laquelle le capteur de contrainte de cisaillement inclut une résistance piézoélectrique.

9. Platine à déplacement programmé XY selon la revendication 1, comprenant en outre des moyens d'entraînement suivant l'axe X.

10. Platine à déplacement programmé XY selon la revendication 9, dans laquelle lesdits moyens d'entraînement suivant l'axe X sont intercalés entre ladite base externe de l'étage et ladite platine intermédiaire déplaçable suivant l'axe X.

11. Platine à déplacement programmé XY selon la revendication 9, dans laquelle lesdits moyens d'entraînement suivant l'axe X sont un transducteur piézoélectrique (272) intercalé entre ladite base externe de la platine et ladite platine intermédiaire déplaçable suivant l'axe X.

12. Platine à déplacement programmé XY selon la revendication 11, dans laquelle ledit transducteur piézoélectrique possède une structure unimorphe métallique stratifiée.

13. Platine à déplacement programmé XY selon la revendication 11, dans laquelle ledit transducteur piézoélectrique est une structure bimorphe.

14. Platine à déplacement programmé XY selon la revendication 11, dans laquelle ledit transducteur piézoélectrique est formé d'un matériau PLZT soumis à contrainte, d'un type de céramique Rainbow qui a été traité de telle sorte que l'une de ses surfaces latérales a été réduite, du point de vue composition, pour l'obtention d'un matériau possédant une composition de cermet alors que le transducteur piézoélectrique constitue une structure unimorphe monolithique.

15. Platine à déplacement programmé XY selon la revendication 1, comprenant en outre des moyens d'entraînement suivant l'axe Y.

16. Platine à déplacement programmé XY selon la revendication 15, dans laquelle lesdits moyens d'entraînement suivant l'axe Y sont intercalés entre ladite platine intermédiaire déplaçable suivant l'axe X et ladite platine interne déplaçable suivant l'axe Y.

17. Platine à déplacement programmé XY selon la revendication 15, dans laquelle lesdits moyens d'entraînement suivant l'axe Y sont un transducteur piézoélectrique (272) intercalé entre ladite platine intermédiaire déplaçable suivant l'axe X et ladite platine interne déplaçable suivant l'axe Y.

18. Platine à déplacement programmé XY selon la revendication 17, dans laquelle ledit transducteur piézoélectrique est une structure unimorphe métallique stratifiée.

19. Platine à déplacement programmé XY selon la revendication 17, dans laquelle ledit transducteur piézoélectrique est une structure bimorphe.

20. Platine à déplacement programmé XY selon la revendication 17, dans laquelle ledit transducteur piézoélectrique est formé d'un matériau PLZT soumis à contrainte d'une céramique du type Rainbow, qui a été traitée de sorte que l'une de ses surfaces a été réduite, du point de vue composition, pour l'obtention d'un matériau possédant une composition de cermet, le transducteur piézoélectrique constituant une structure unimorphe monolithique.

## Patentansprüche

1. Mikrobearbeiteter X-Y-Abtasttisch, der umfasst:
einen äußeren Tischuntersatz (202), der in Bezug auf eine abzutastende Fläche stationär gehalten wird;
einen Zwischen-X-Achsen-Tisch (204), der mit dem Tischuntersatz verbunden ist und von ihm mit einer Vielzahl von Biegeelementen (flexures) (214) getragen wird,
einen inneren Y-Achsen-Tisch (212), der mit dem X-Achsen-Tisch (204) verbunden ist und von ihm mit einer Vielzahl von Biegeelementen (214) getragen wird,
und eine Erfassungseinrichtung, die von dem X-Achsen-Tisch und dem Y-Achsen-Tisch getragen und zur X-Achsen- und Y-Achsen-Verschiebung geführt wird;
**dadurch gekennzeichnet, dass**:
in wenigstens einem der Biegeelemente (206), die den Tischuntersatz und den X-Achsen-Tisch verbinden, ein Scherspannungssensor (222) ausgebildet ist, um Spannung in diesem Biegeelement zu erfassen;
in wenigstens einem der Biegeelemente (214), die den X-Achsen-Tisch und den Y-Achsen-Tisch verbinden, ein Scherspannungssensor (222) ausgebildet ist, um Spannung in diesem Biegeelement zu erfassen;
der Tischuntersatz, der X-Achsen-Tisch, der Y-Achsen-Tisch und die Biegeelemente sämtlich monolithisch aus einer Haibleiter-Elnkristall-Siliziumschicht eines Substrats hergestellt sind.

2. X-Y-Abtasttisch nach Anspruch 1, wobei die Erfassungseinrichtung den X-Y-Abtasttisch zum Erfassen einer Topographie einer Oberfläche einrichtet und die Erfassungseinrichtung enthält:
einen Z-Achsen-Tisch (238) mit Torsionsstäben (242), die von einander gegenüberliegenden Seiten des Y-Achsen-Tischs nach innen vorstehen und entlang einer gemeinsamen Achse (244) ausgerichtet sind, um einen Z-Achsen-Flügel (246) in dem Y-Achsen-Tisch zu tragen, wobei die Torsionsstäbe und der Z-Achsen-Flügel monolithisch aus einer Halbleiter-Elnkrlstall-Siliziumschicht eines Substrats zusammen mit dem Tischuntersatz, dem X-Achsen-Tisch, dem Y-Achsen-Tisch und den Biegeelemente hergestellt sind und der Z-Achsen-Flügel in dem Y-Achsen-Tisch um die gemeinsame Achse der Torsionsstäbe herum drehbar getragen wird und eine Ruheebene bildet, wenn keine äußere Kraft auf den Z-Achsen-Flügel ausgeübt wird, und durch eine Kraft, die auf den Z-Achsen-Flügel ausgeübt wird, um die gemeinsame Achse der Torsionsstäbe an eine Drehposition gedreht werden kann, die gegenüber der Ruheebene verschoben ist, wobei der Z-Achsen-Flügel zum Führen eines Abtastsensors eingerichtet ist;
eine Antriebseinrichtung (292), die den Z-Achsen-Flügel zwingt, sich um die gemeinsame Achse der Torsionsstäbe zu drehen;
und eine Drehpositions-Erfassungseinrichtung, die die Drehposition des Z-Achsen-Flügels um die gemeinsame Achse der Torsionsstäbe misst.

3. X-Y-Abtasttisch nach Anspruch 2, wobei der Abtastsensor, der von dem Z-Achsen-Tisch geführt wird, ein mikrobearbeiteter topographischer Kopf (100) ist, der zum Einsatz beim Erfassen der Topographie einer Oberfläche eingerichtet ist, wobei der topographische Kopf enthält:
einen Rahmen (102), von dem nach innen einander gegenüberliegende Torsionsstäbe (104) vorstehen, die entlang einer gemeinsamen Achse (106) ausgerichtet sind und die einen Mittelflügel (108) in dem Rahmen tragen, wobei der Rahmen, die Torsionsstäbe und der Mittelflügel sämtlich monolithisch aus einer Halbleiter-Einkristall-Siliziumschicht eines Substrats hergestellt sind, der Mittelflügel in dem Rahmen um die gemeinsame Achse der Torsionsstäbe herum drehbar getragen wird, eine Mitte aufweist, eine Ruhebene (114) bildet, wenn keine äußere Kraft auf den Mittelflügel ausgeübt wird, und durch eine Kraft, die auf den Mittelflügel ausgeübt wird, um die gemeinsame Achse der Torsionsstäbe an eine Drehposition gedreht werden kann, die gegenüber der Ruheebene verschoben ist, wobei der Mittelflügel eine Spitze (118) enthält, die von dem Mittelflügel von den Torsionsstäben entfernt nach außen vorsteht, wobei die Spitze zum Anliegen an einer Fläche (122) eingerichtet ist, um die Topographie derselben zu erfassen;
eine Antriebseinrichtung (124, 128), die den Mittelflügel zwingt, sich um die gemeinsame Achse der Torsionsstäbe zu drehen; und
eine Drehpositions-Erfassungseinrichtung (142), die die Drehposition des Mittelflügels um die gemeinsame Achse der Torsionsstäbe misst.

4. X-Y-Abtasttisch nach Anspruch 2, wobei die Antriebseinrichtung ein laminierter Metall-Unimorph ist, der mit dem Z-Achsen-Flügel verbunden ist.

5. X-Y-Abtasttisch nach Anspruch 2, wobei die Antriebseinrichtung ein Bimorph ist, der mit dem Z-Achsen-Flügel verbunden ist.

6. X-Y-Abtasttisch nach Anspruch 2, wobei die Antriebseinrichtung aus lastgespanntem PLZT-Material eines Keramikmaterials vom Typ "Rainbow" besteht, das so bearbeitet worden ist, dass eine Seitenfläche desselben hinsichtlich ihrer Zusammensetzung reduziert worden ist, um ein Material mit einer Cermet-Zusammensetzung zu erzeugen, so dass die Antriebseinrichtung einen monolithischen Unimorph bildet und der Unimorph mit dem Z-Achsen-Flügel verbunden ist.

7. X-Y-Abtasttisch nach Anspruch 1, wobei der Scherspannungssensor einen Piezo-Sensor enthält.

8. X-Y-Abtasttisch nach Anspruch 1, wobei der Scherspannungssensor einen Piezo-Widerstand enthält.

9. X-Y-Abtasttisch nach Anspruch 1, der des Weiteren eine X-Achsen-Antriebseinrichtung umfasst.

10. X-Y-Abtasttisch nach Anspruch 9, wobei die X-Achsen-Antriebseinrichtung zwischen dem äußeren Tischuntersatz und dem Zwischen-X-Achsen-Tisch angeordnet ist.

11. X-Y-Abtasttisch nach Anspruch 9, wobei die X-Achsen-Antriebseinrichtung ein Piezo-Wandler (272) ist, der zwischen dem äußeren Tischuntersatz und dem Zwischen-X-Achsen-Tisch angeordnet ist.

12. X-Y-Abtasttisch nach Anspruch 11, wobei der Piezo-Wandler ein laminierter Metall-Unimorph ist.

13. X-Y-Abtasttisch nach Anspruch 11, wobei der Piezo-Wandler ein Bimorph ist.

14. X-Y-Abtasttisch nach Anspruch 11, wobei der Piezo-Wandler aus lastgespanntem PLZT-Material eines Keramikmaterials vom Typ "Rainbow" besteht, das so bearbeitet worden ist, dass eine Seitenfläche desselben hinsichtlich ihrer Zusammensetzung reduziert worden ist, um ein Material mit einer Cermet-Zusammensetzung zu erzeugen, so dass der Piezo-Wandler einen monolithischen Unimorph bildet.

15. X-Y-Abtasttisch nach Anspruch 1, der des Weiteren eine Y-Achsen-Antriebseinrichtung umfasst.

16. X-Y-Abtasttisch nach Anspruch 15, wobei die Y-Achsen-Antriebseinrichtung zwischen dem X-Achsen-Tisch und dem inneren Y-Achsen-Tisch angeordnet ist.

17. X-Y-Abtasttisch nach Anspruch 15, wobei die Y-Achsen-Antriebseinrichtung ein Piezo-Wandler (272) ist, der zwischen dem Zwischen-X-Achsen-Tisch und dem inneren Y-Achsen-Tisch angeordnet ist.

18. X-Y-Abtasttisch nach Anspruch 17, wobei der Piezo-Wandler ein laminierter Metall-Unimorph ist.

19. X-Y-Abtasttisch nach Anspruch 17, wobei der Piezo-Wandler ein Bimorph ist.

20. X-Y-Abtasttisch nach Anspruch 17, wobei der Piezo-Wandler aus lastgespanntem PLZT-Material eines Keramikmaterials vom Typ "Rainbow" besteht, das so bearbeitet worden ist, dass eine Seitenfläche desselben hinsichtlich ihrer Zusammensetzung reduziert worden ist, um ein Material mit einer Cermet-Zusammensetzung herzustellen, so dass der Piezowandler einen monolithischen Unimorph bildet.
